## Europäisches Patentamt

## European Patent Office

## Office européen des brevets

(11) Veröffentlichungsnummer: **0 258 470**
**B1**

(12) **EUROPÄISCHE PATENTSCHRIFT**

(45) Veröffentlichungstag der Patentschrift:
05.09.90

(51) Int. Cl.⁵: **H01L 39/24**

(21) Anmeldenummer: **86112040.0**

(22) Anmeldetag: **01.09.86**

(54) Verfahren zur Herstellung von Blöcken aus PbxMoySz-Chevrelphasen.

(43) Veröffentlichungstag der Anmeldung:
**09.03.88 Patentblatt 88/10**

(45) Bekanntmachung des Hinweises auf die Patenterteilung:
**05.09.90 Patentblatt 90/36**

(84) Benannte Vertragsstaaten:
**AT BE CH DE FR GB IT LI NL SE**

(56) Entgegenhaltungen:
**EP-A- 0 181 496**

(73) Patentinhaber: **KERNFORSCHUNGSZENTRUM KARLSRUHE GMBH, Weberstrasse 5 Postfach 3640, D-7500 Karlsruhe 1(DE)**

(72) Erfinder: **Flükiger, Rene, Dr., Schneidemühlerstrasse 6E, D-7500 Karlsruhe 1(DE)**
Erfinder: **Goldacker, Wilfried, Dr., Trübnerstrasse 18, D-6900 Heidelberg(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft ein Verfahren zur Herstellung von Blöcken aus $Pb_xMo_yS_z$-Chevrelphasen, wobei x = 0,9 bis 1,2, y = 6,0 bis 6,4 und z = 7 bis 8 bedeuten, bei welchem Pulver aus den Elementen und/oder aus den entsprechenden Metallsulfiden als Ausgangsmaterialien nach guter Durchmischung einem isostatischen Heißpreßvorgang bei einer Temperatur im Bereich von 800° C bis 1200° C und einem Druck von mehr als 10 MPa (> 100 bar) unterzogen werden.

Zur Herstellung von Supraleiterdrähten mit ternären supraleitenden Phasen, z. B. in Form von Metall-Mo-Chalkogeniden, sogenannten Chevrel-Phasen, wurde bereits vorgeschlagen, Proben aus $Pb_xMo_yS_z$ (PMS) entweder aus vorreagierten Pulvern oder aus einer Mischung von Pulvern von Mo, $MoS_2$ und PbS durch eine Heißpreßtechnik zu präparieren (D. Cattani, et al 9th International Conference on Magnet Technology, Zürich, Schweiz, 9. - 13. September 1985, Heft MT-9 1985, Seiten 560 bis 563). Als optimale Bedingungen für das Heißpressen wurden hierbei 1100°C, eine Stunde Heißpreßdauer und ein Druck von 240 MPa angesehen. Es sollen dabei homogene und dichte PMS-Proben mit einer Korngröße von ca. 1 µm und einer Dichte von > 96 % der theoretischen Dichte erhalten worden sein. Zur Verbesserung der supraleitenden Parameter des PMS wurden der ternären Phase geringe Mengen Gallium bzw. Galliumsulfid zugesetzt. Bei der Fabrikation von PMS-Drähten von mehreren hundert Metern Länge wurde zur Verringerung des üblicherweise auftretenden Abfalles der kritischen Stromdichte gegenüber den Werten, gemessen an PMS-Proben, eine Kombination einer Stahlhülle und einer Molybdänhülle als Matrix für die PMS-Drähte verwendet.

Von Cattani et al wurde jedoch in der gleichen Druckschrift erwähnt, daß bei einer Verwendung einer Mischung von Pulvern von PbS, $MoS_2$ und Mo unter den genannten optimierten Bedingungen, selbst bei einer Heißpreßtemperatur von 1500° C, keine vollständige Reaktion zu PMS zu erreichen ist. Ausscheidungen von $MoS_2$ und $Mo_2S_3$ wurden beobachtet. Cattani et al verwendeten eine modifizierte hydraulische, uniaxiale Presse, in welcher sie die Probe bzw. das Pulvergemisch auf die gewünschte Temperatur erhitzt haben. Ein weiterer Nachteil dieser Verfahrensweise liegt darin, daß bei größeren Pulvermengen (als die für einzelne Pellets erforderliche Menge) keine in jede Raumrichtung gleichmäßige Dichte zu erreichen ist. Dies wäre jedoch für die Herstellung eines Supraleiterdrahtes, welcher gute Supraleitereigenschaften aufweisen soll, unbedingt erforderlich.

Dieses Verfahren beinhaltet eine abschließende Erholungsglühung bei Temperaturen um 1000° C, um die ursprünglichen supraleitenden Eigenschaften der PMS-Phase wieder zu erhalten (s. B. Seeber, C. Rossel, O.Fischer, W. Glätzle: IEEE Trans. Mag. MAG-19, Seite 402 (1983)).

In einem anderen Verfahren wurde eine Pulvermischung aus Mo-, Pb- und $MoS_2$-Pulvern hydrostatisch zu Pellets gepreßt (kaltgepreßt), wonach die Pellets in ein Tantalrohr eingeführt wurden und das Tantalrohr in ein stabilisierendes Kupferrohr und das ganze bei Raumtemperatur zu einem Draht von einem Durchmesser von 1,05 mm gezogen wurde. Als Barriere gegen ein unerwünschtes Verhalten des Schwefels wurde außer Tantal, welches gute Kaltbearbeitungseigenschaften aufweist, Molybdän, Niob und Silber vorgeschlagen. Der Draht in seinen Endabmessungen wurde dann zwei Stunden lang wärmebehandelt bei 1000° C um die PMS-Phase zu erhalten. Für eine solche abschließende Wärmebehandlung wurde das isostatische Heißpressen (HIP) bei einem Druck von 100 bis 200 MPa und einer Temperatur zwischen 850° C und 1050° C für die Dauer zwischen ein und vier Stunden vorgeschlagen (Y. Kubo et al, Int. Cryogenic Materials Conference, August 1985, Boston, USA; veröffentlicht in Adv. Cryo. Eng., Vol. 32, Seite 1085 (1986)).

Bei beiden Verfahren können die Nachteile des auftretenden Kornwachstums dadurch begrenzt werden, daß die Endabmessungen der PMS-Filamente ≤ 1 µm gehalten werden. Als Folge der schlechten Verformungseigenschaften von Mo kann keine homogene Verteilung dieses Elementes in den Filamenten erreicht werden, was sich nachteilig auf die kritische Stromdichte eines langen Drahtes auswirkt.

Alle bisher bekannt gewordenen Verfahren zur Herstellung von Chevrel-Phasen, deren wichtigster Vertreter $Pb_xMo_yS_z$ durch das höchste bekannte kritische Magnetfeld $B_{C2}$= ca. 60 Tesla als zukünftiger Supraleiter für die Höchstfelderzeugung von größtem technischen Interesse ist, sind mit mehr oder weniger gutem Erfolg nur im Labormaßstab, d. h. für Pulvermengen in der Größenordnung von 100 g durchführbar. Hinderungsgrund für eine wirtschaftliche Übersetzung dieser Labor-Verfahren in den technischen Maßstab sind einerseits verarbeitungstechnische Probleme bei der Verformung eines mit Ausgangsmaterial oder eines mit $Pb_xMo_yS_z$-Pulver gefüllten, zylindrischen Blocks oder Rohres zu einem Multifilamentdraht, andererseits die Degradation der supraleitenden Eigenschaften als Folge der mechanischen Verformung und der zunehmende Aufwand der Präparation mit ansteigender Menge des $Pb_xMo_yS_z$-Pulvers. Zur Verbesserung der Multifilamentsupraleiter ist die Zahl der Filamente zu erhöhen, deren Enddurchmesser zu reduzieren und die Entwicklung einer Matrix mit Stromstabilisierung durchzuführen. Zusätzlich müssen die Korngrößen in den Filamenten reduziert werden, um die Stromtragfähigkeit zu erhöhen. Bei der Verarbeitung zunehmender Mengen an Ausgangsmaterialien sind eine hohe Dichte des Chevrelphasenblockes, eine gleichmäßige, weitgehend einphasige Zusammensetzung, sowie eine sich gleichmäßig durch den Block erstreckende Dichte nicht mehr gewährleistet.

Der Erfindung liegt die Aufgabe zugrunde, ein Verfahren zur Herstellung von weitgehend einphasigen $Pb_xMo_yS_z$-Blöcken, wobei x = 0,9 bis 1,2, y = 6,0 bis 6,4 und z = 7 bis 8 bedeuten, mit hoher Dichte von ≧ 90 % der theoretischen Dichte im kg-Mengen-Maßstab zu schaffen, welche homogen, gasblasenfrei und ohne Dichtegradient sind.

Die Aufgabe wird erfindungsgemäß dadurch gelöst, daß

1) kg-Mengen der gemischten Ausgangsmaterialien in ein metallisches Behältnis eingebracht werden,
2) danach das Behältnis bis zu einem Druck ≦ $10^4$ Pa evakuiert wird,
3) das evakuierte Behältnis mit dem Pulvergemisch bei einem während des ganzen Vorganges konstant gehaltenen Druckes im Bereich von 100 MPa bis 300 MPa bei Aufheizraten im Bereich von 10° C/h bis 1000° C/h und bei einer Temperatur im Bereich von 800° C bis 1200° C heißgepreßt wird, wobei die Ausgangsmaterialien zur Chevrel-Phase reagieren, und
4) nach einer Haltezeit des Druckes und der Endtemperatur im Bereich von 10 Stunden bis 100 Stunden, abhängig von der eingebrachten Pulvermenge, der erhaltene Block mit einer Abkühlrate im Bereich von 50° C/h bis 500° C/h kontrolliert bei konstant beibehaltenem Druck abgekühlt wird.

Eine vorteilhafte Ausbildung des erfindungsgemäßen Verfahrens ist dadurch gekennzeichnet, daß das evakuierte Behältnis mit Edelgas gefüllt wird, danach wieder evakuiert und anschließend bei Temperaturen unterhalb 300° C ausgeheizt wird.

Durch die erfindungsgemäßen Verfahrensschritte wird in einem Arbeitsgang eine vollständige Bildung der Chevrel-Phase aus den Ausgangsmaterialien erreicht und eine hohe, gleichmäßige Kompaktierung des Reaktionsproduktes erzielt. Die im erhaltenen Block durch das erfindungsgemäße Verfahren erzeugten Korngrößen spielen für die Weiterverarbeitung des Blockes zu Multifilamentdrähten praktisch keine Rolle, da der Umformfaktor bis zu den Endabmessungen der Filamente um einige Größenordnungen höher liegt als der Umformfaktor bei den bekannten Verfahren. Das metallische Behältnis kann aus einem Material bestehen, welches als Barriere für die Chevrel-Phasen dienen kann, oder aus einem Material, welches sich leicht zu Drähten verarbeiten läßt und innen mit einem Barrierenmaterial ausgekleidet ist.

Zwar wurde aus der Europäischen Offenlegungsschrift 0 181 496 A1 ein Verfahren zur Herstellung eines supraleitenden Drahtes unter Verwendung eines Metall-Molybdän-Chalkogenides (Chevrel-Phase) in der supraleitenden Phase, insbesondere von PbMo₆S₈, bekannt, bei welchem die supraleitende Phase oder die Ausgangskomponenten zur Bildung einer solchen Phase vakuumdicht in einen Molybdän-Mantel und dieser vorteilhafterweise in einen Stahlmantel eingebracht und diese Einheit anschließend durch Warmumformen in mehreren Verfahrensschritten zu einem supraleitendem Draht verarbeitet wird, doch wird dort die supraleitende Phase entweder nicht kompaktiert vor dem Strangpressen und/oder Warmziehen etc. oder die Kompaktierung der pulverförmigen supraleitenden Phase wird vor dem Einbringen in den Molybdän-Mantel durch kaltisostatisches Pressen verdichtet.

Hieraus ergeben sich fol gende Nachteile: Die Verfahrensführung ist umständlich, zeitraubend und führt zu Produkten, welche bereits im Ansatz zur Drahtherstellung keine optimale Dichte aufweisen. Außerdem kann das Pressen der pulverförmigen supraleitenden Phase vor dem Einbringen in den Molybdän-Mantel nur unter Verwendung von Chevrel-Phasenpulver erfolgen, so daß die Chevrel-Phase in einem vorangehenden, separaten Verfahrensschritt erzeugt werden muß und das Erzeugnis zu Pulver verarbeitet werden muß.

Die Ausgangsmaterialien, beispielsweise Pb-, PbS-, MoS₂- und Mo-Pulver, werden in entsprechendem Mengenverhältnis intensiv miteinander vermischt. Danach werden sie in eine vakuumdichte mit einem Pumpstutzen versehene Kapsel aus VA-Stahl (oder anderen geeigneten Materialien) eingefüllt (unter Klopfdichte) und eingeschweißt. Dies kann zur Vermeidung erhöhten Sauerstoffeintrags in Inertgasatmosphäre erfolgen. Die innere mit dem Pulver in Kontakt stehende Kapselwand ist mit Folie eines nicht mit dem Pulver reagierenden Materials wie Mo, Ta ausgekleidet.

Nach Evakuierung der beladenen Kapsel wird mit Inertgas gespült, evakuiert und bei moderaten Temperaturen (100 - 200° C) ausgeheizt. Danach wird der Pumpstutzen der evakuierten Kapsel zugeschweißt (durch Elektronenstrahlschweißen). Die Kapsel ist nun für die Durchführung des HIP-Zyklus vorbereitet. Das heißisostatische Pressen findet bei Drücken der Größenordnung 100 MPa statt, die Temperatur wird auf die Reaktionstemperatur der Chevrel-Phase von 1000° bis 1100° C gebracht. Je nach Probenvolumen und -geometrie sind unterschiedliche Reaktionszeiten der Größenordnung 10 - 30 h angebracht. Durch diese Verfahrensweise wird durch den Aussendruck an der Kapsel ein Bersten bzw. Explodieren des Behältnisses während der Reaktion der Pulver zur Chevrel- Phase verhindert und somit die Bearbeitung großer Pulvermengen gestattet. Eine besondere Vorsicht beim Aufheizprozeß ist daher nicht erforderlich. Die gleichzeitige hydrostatische Verdichtung des Pb-Mo₆S₈-Pulvers zu einem festen Block, der spanabhebend bearbeitet werden kann, ermöglicht es, daß der Block direkt nach Einbringen in eine Matrix dem ersten Verformungsschritt (z. B. Strangpressen) zugeführt werden kann. Die Geometrie der HIP-Kapsel kann unter Einberechnung des Verdichtungsgrades durch das Hippen beliebig an die gewünschte Form des PbMo₆S₈-Blockes angepaßt werden, zwecks Minimierung des Materialverlustes bei der Weiterverarbeitung.

Die Abkühlgeschwindigkeit des HIP-Zyklus wird je nach HIP-Kapsel zur Vermeidung thermisch verursachter Risse und Brüche kontrolliert eingestellt.

Ein weiterer Vorteil des Verfahrens ist die Möglichkeit, beim HIP-Prozeß dem PbMo₆S₈-Volumen ein Matrixmaterial für den Verformungsprozeß der Drahtherstellung zu umpressen. Dies kann je nach Gegebenheit im gleichen HIP-Zyklus oder in einem wesentlich schneller ablaufenden zweiten HIP-Zyklus durchgeführt werden und führt zum bestmöglichen "bonding" zwischen Matrix und der PbMo₆S₈-Phase.

## Patentansprüche

1. Verfahren zur Herstellung von Blöcken aus $Pb_xMo_yS_z$--Chevrelphasen, wobei x = 0,9 bis 1,2, y = 6,0 bis 6,4 und z = 7 bis 8 bedeuten, bei welchem Pulver aus den Elementen und/oder aus den entsprechenden Metallsulfiden als Ausgangsmaterialien nach guter Durchmischung einem isostatischen Heißpreßvorgang bei einer Temperatur im Bereich von 800° C bis 1200° C und einem Druck von mehr als 10 MPa (>100 bar) unterzogen werden, dadurch gekennzeichnet, daß

1) kg-Mengen der gemischten Ausgangsmaterialien in ein metallisches Behältnis eingebracht werden,

2) danach das Behältnis bis zu einem Druck ≦ $10^4$ Pa evakuiert wird,

3) das evakuierte Behältnis mit dem Pulvergemisch bei einem während des ganzen Vorganges konstant gehaltenen Druckes im Bereich von 100 MPa bis 300 MPa bei Aufheizraten im Bereich von 10° C/h bis 1000° C/h und bei einer Temperatur im Bereich von 800° C bis 1200° C heißgepreßt wird, wobei die Ausgangsmaterialien zur Chevrel-Phase reagieren, und

4) nach einer Haltezeit des Druckes und der Endtemperatur im Bereich von 10 Stunden bis 100 Stunden, abhängig von der eingebrachten Pulvermenge, der erhaltene Block mit einer Abkühlrate im Bereich von 50° C/h bis 500° C/h kontrolliert bei konstant beibehaltenem Druck abgekühlt wird.

2. Verfahren nach Anspruch 1, dadurch gekennzeichnet, daß das evakuierte Behältnis mit Edelgas gefüllt wird, danach wieder evakuiert und anschließend bei Temperaturen unterhalb 300° C ausgeheizt wird.

## Claims

1. Method of producing blocks form $Pb_xMo_yS_z$ Chevrel phases, x being 0.9 to 1.2, y being 6.0 to 6.4 and z being 7 to 8, wherein, after through mixing, powders from the elements and/or from the corresponding metallic sulphides as starting materials are subjected to an isostatic hot-pressing process at a temperature ranging between 800°C and 1200°C and to a pressure of more than 10 MPa (> 100 bars), characterised in that

1) kg quantities of the mixed starting materials are introduced into a metal container;

2) then the container is evacuated up to a pressure 10 ≤ Pa;

3) the evacuated container with the powder mixture is hot-pressed at a pressure, which is kept constant during the entire process, ranging between 100 MPa and 300 MPa at heating rates ranging between 10°C/h and 1000°C/h and at a temperature ranging between 800°C and 1200°C, whereby the starting materials react to form the Chevrel phase; and

4) after the pressure and the final temperature have been maintained for a period of time ranging between 10 hours and 100 hours, depending on the quantity of powder introduced, the block which is obtained is cooled, in a controlled manner at a constantly maintained pressure, at a cooling rate ranging between 50°C/h and 500°C/h.

2. Method according to claim 1, characterised in that the evacuated container is filled with inert gas, then evacuated again and subsequently heated-out at temperatures below 300°C.

## Revendications

1. Procédé de préparation de blocs de phases Chevrel $Pb_xMo_yS_z$ dans lesquels on a x = 0,9 à 1,2, y = 6,0 à 6,4 et z = 7 à 8, dans lequel on soumet la poudre des éléments et/ou des sulfures métalliques correspondants comme matériaux de départ, après un bon mélange, à un processus de pressage à chaud à une température comprise entre 800°C et 1200°C et à une pression supérieure à 10 MPa (> 100 bar), caractérisé en ce que:

1) on place des quantités se chiffrant par kg des matériaux de départ mélangés dans un récipient métallique,

2) ensuite le récipient est mis sous vide jusqu'à une pression ≤ $10^4$ Pa,

3) on presse à chaud le récipient mis sous vide avec le mélange de poudre, sous une pression maintenue constante pendant tout le processus comprise entre 100 MPa et 300 MPa, à des vitesses de chauffage comprises entre 10°C/h et 1000°C/h, à une température comprise entre 800°C et 1200°C, ce qui fait réagir les matériaux de départ pour donner une phase de Chevrel, et

4) après maintien de la pression et de la température finale entre 10 heures et 100 heures, en fonction de la quantité de poudre mise en oeuvre, on refroidit le bloc obtenu à une vitesse de refroidissement comprise entre 50°C/h et 500°C/h et maitrisée tout en maintenant constante la pression.

2. Procédé selon la revendication 1, caractérisé en ce qu'on remplit le récipient mis sous vide de gaz rare, puis on met sous vide à nouveau et ensuite on chauffe à des températures inférieures à 300°C.